# EUROPEAN PATENT APPLICATION

(11) **EP 4 529 402 A1**
(43) Date of publication of application: **26.03.2025**
(21) Application number: 24198147.1
(22) Date of filing: 03.09.2024
(51) Int. Cl.: H10K 59/80, H10K 59/121, H10K 59/122, H10K 59/40

(54) **DISPLAY DEVICE**

(30) Priority: 21.09.2023 KR 20230126165
(71) Applicant: LG Display Co., Ltd., Seoul 150-721 (KR)
(72) Inventor: JIN, You Yong, Paju-si, Gyeonggi-do (KR); HYUN, Joo Bong, Paju-si, Gyeonggi-do (KR); KIM, So Yeon, Paju-si, Gyeonggi-do (KR)
(74) Representative: Viering, Jentschura & Partner mbB Patent- und Rechtsanwälte

(57) **Abstract**

A display device can include a bank (160) exposing a first open portion (OA1) of a first sub-pixel and a first open portion (OA1) of a second sub-pixel, a plurality of first lenses (L1, 241, 341, 441, 541, 641, 741) disposed to correspond to the first open portion (OA1) of the first sub-pixel and the first open portion (OA1) of the second sub-pixel, an optical layer (220, 320, 420, 520, 620, 720, 920) disposed between the bank (160) and the plurality of first lenses (L1, 241, 341, 441, 541, 641, 741), the optical layer (220, 320, 420, 520, 620, 720, 920) including a first groove (H, 220a, 320a, 420a, 520a, 620a, 720a, 920a) between one of the plurality of first lenses (L1, 241, 341, 441, 541, 641, 741) corresponding to the first open portion (OA1) of the first sub-pixel and another one of the plurality of first lenses (L1, 241, 341, 441, 541, 641, 741) corresponding to the first open portion (OA1) of the second sub-pixel, the first groove (H, 220a, 320a, 420a, 520a, 620a, 720a, 920a) having a first thickness (t1), and a filler (L3, 243, 343, 443, 543, 643, 743, 943) disposed in the first groove (H, 220a, 320a, 420a, 520a, 620a, 720a, 920a) of the optical layer (220, 320, 420, 520, 620, 720, 920). Also, the filler (L3, 243, 343, 443, 543, 643, 743, 943) is aligned with two of the plurality of first lenses (L1, 241, 341, 441, 541, 641, 741) in a first direction (D1).

## Description

### CROSS-REFERENCES TO RELATED APPLICATIONS

This application claims priority to Korean Patent Application No. 10-2023-0126165, filed on September 21, 2023.

### BACKGROUND

### Technical Field

The present disclosure relates to a display device capable of stably depositing a lens.

### Discussion of the Related Art

Recently, with the advent of a full-scale information age, display devices capable of visually expressing electrical information signals have rapidly developed. Correspondingly, various display devices, such as liquid crystal display devices (LCDs) and organic light-emitting display devices (OLEDs), have been developed and used in various fields.

Among display devices, a light-emitting display device includes a self-light-emitting device which does not require a separate light source. Therefore, a light-emitting display device has advantages of a light weight and a thin profile. Further, a light-emitting display device has no limitation on viewing angle due to the self-light-emitting properties thereof.

Such a light-emitting display device can include lenses corresponding to a plurality of respective light-emitting devices in order to control the viewing angle for privacy protection, information protection, application thereof to vehicular display devices, etc.

Lenses for viewing angle control can include a first lens, which has a narrow viewing angle in one of an up-down direction and a left-right direction and a wide viewing angle in the other direction, and a second lens, which has a narrow viewing angle both in the up-down direction and in the left-right direction.

Among these lenses, the first lens having a wide viewing angle in one of the up-down direction and the left-right direction can be formed to be elongated in a direction in which the first lens has the wide viewing angle. The first lenses can be provided on one plane, and side surfaces of the plurality of first lenses adjacent to each other may undesirably come into contact with each other during a reflow process. In this situation, the plurality of first lenses can be consecutively disposed linearly in a first direction (e.g., forming a long dam type of structure).

However, a sufficient step difference may not be formed between the first lenses linearly disposed. When a planarization film is formed on the first lenses using an organic insulating material, the linear alignment of the first lenses may act as a structure that impedes the flow of the organic insulating material (e.g., the first lenses may connect to form a long continuous dam structure). In addition, a relatively large fixing force may be desirable for the first lenses consecutively disposed on the same plane in the first direction compared to individual lenses not consecutively disposed on the same plane (e.g., the first lenses may have issues regarding peeling off). Because the structure of the first lenses can impede flow of the planarization film, lack of planarization can occur in some areas and an upper surface can become too thin, too thick, wavy or uneven. In the area where the planarization film is not sufficiently applied, the first lenses consecutively disposed linearly in the first direction may get peeled off more easily and the image may become impair to due to an uneven upper surface. Thus, there exists is a need for creating a flat surface above the lenses for improving image quality and for securely fixing the first lenses in place.

### SUMMARY OF THE DISCLOSURE

Accordingly, the present disclosure is directed to a display device that substantially obviates one or more problems due to limitations and disadvantages of the related art.

An object of the present disclosure is to provide a display device capable of preventing side surfaces of first lenses disposed in a first direction and having a wide viewing angle from coming into contact with each other and capable of allowing the surface of a planarization film formed on the first lenses to be formed flat by creating a defined step difference between the first lenses.

In addition, another object of the present disclosure is to provide a display device capable of preventing peeling off of the first lenses by allowing the entire surface of the planarization film to be formed evenly and flat on the first lenses to firmly secure them in place. There is provided a display device in which, when lenses including the first lenses and second lenses are disposed corresponding to a plurality of open portions, it is possible to separate the side surfaces of the first lenses from each other without increasing the size of a non-open portion between the plurality of open portions, thereby allowing the planarization film to be formed evenly on the first lenses. In other words, the first lenses can be packed close together and still be individually defined and spaced apart from each other.

Additional advantages, objects, and features of the disclosure will be set forth in part in the description which follows and in part will become apparent to those having ordinary skill in the art upon examination of the following or can be learned from practice of the disclosure. The objects and other advantages of the disclosure can be realized and attained by the structure particularly pointed out in the written description and claims hereof as well as the appended drawings.

In a display device of the present disclosure, a groove is formed in a portion of an optical layer located under the first lenses to correspond to an area between the first lenses disposed in a first direction, thereby creating a defined step difference between the first lenses. Accordingly, in the display device of the present disclosure, since the side surfaces of the first lenses are separated from each other, a planarization film can be formed to be flat on the first lenses. According to an aspect of the present disclosure display device according to claim 1 is provided. According to another aspect of the present disclosure, a display device according to claim 9 is provided. According to another aspect of the present disclosure, a display device according to claim 12 is provided. Further aspects are described in the dependent claims.

To achieve the aforementioned objects and other advantages and in accordance with the purpose of the disclosure, as embodied and broadly described herein, a display device according to an aspect of the present disclosure includes a bank exposing a first open portion included in each of a first sub-pixel and a second sub-pixel, a first lens disposed on the bank to correspond to the first open portion of each of the first sub-pixel and the second sub-pixel, an optical layer disposed between the bank and the first lens and including a groove having a first thickness and located between the first lens corresponding to the first open portion of the first sub-pixel and the first lens corresponding to the first open portion of the second sub-pixel, and a filler disposed in the groove in the optical layer. The first lens corresponding to the first open portion of the first sub-pixel, the first lens corresponding to the first open portion of the second sub-pixel, and the filler are disposed in a row in a first direction.

It is to be understood that both the foregoing general description and the following detailed description of the present disclosure are examples and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure. In the drawings:
FIG. 1 is a plan view of a display device according to an embodiment of the present disclosure;
FIGs. 2A to 2C are enlarged views of FIG. 1 according to an embodiment of the present disclosure;
FIG. 3 is a cross-sectional view taken along lines I-I' and II-II' in FIG. 1 according to an embodiment of the present disclosure;
FIG. 4 is a cross-sectional view taken along line III-III' in FIG. 1 according to an embodiment of the present disclosure;
FIG. 5 is a cross-sectional view taken along line IV-IV' in FIG. 1 according to an embodiment of the present disclosure;
FIG. 6, including parts (a)-(c), is a cross-sectional view of other embodiments of the present disclosure of a groove in FIG. 4;
FIG. 7 is a cross-sectional view of still another embodiment of the present disclosure for the groove in FIG. 4;
FIG. 8 is a cross-sectional view of another embodiment of the present disclosure for a sensor electrode in FIG. 4;
FIG. 9 is a plan view of a display device according to another embodiment of the present disclosure;
FIG. 10 is a cross-sectional view taken along line V-V' in FIG. 9 according to an embodiment of the present disclosure; and
FIGs. 11A to 11F are cross-sectional views showing a process of manufacturing the display device shown in FIG. 4 according to an embodiment of the present disclosure.

### DETAILED DESCRIPTION OF THE EMBODIMENTS

Advantages and features of the present disclosure and methods for achieving the same will be made clear from embodiments described below in detail with reference to the accompanying drawings. The present disclosure can, however, be embodied in many different forms, and should not be construed as being limited to the embodiments set forth herein. Rather, these embodiments are provided so that this disclosure will be thorough and complete and will fully convey the scope of the disclosure to those skilled in the art. The present disclosure is defined only by the scope of the claims.

In the drawings for explaining the example embodiments of the present disclosure, for example, the illustrated shape, size, ratio, angle, and number are given by way of example, and thus, are not limited to the disclosure. Throughout the present specification, the same reference numerals designate the same constituent elements. In addition, in the following description of the present disclosure, a detailed description of known functions and configurations incorporated herein will be omitted when it can make the subject matter of the present disclosure rather unclear.

The terms "comprises," "includes," and/or "has" used in this specification, do not preclude the presence or addition of other elements unless used along with the term "only." The singular forms are intended to include the plural forms as well, unless the context clearly indicates otherwise.

In the interpretation of constituent elements, the constituent elements are interpreted as including an error range even if there is no explicit description thereof.

In the description of the various embodiments, when describing positional relationships, for example, when the positional relationship between two parts is described using "on," "above," "below," "next to" or the like, one or more other parts can be located between the two parts unless the term "directly" or "closely" is used.

In the description of the various embodiments of the present disclosure, when describing temporal relationships, for example, when the temporal relationship between two actions is described using "after," "subsequently," "next," "before" or the like, the actions may not occur in succession unless the term "directly" or "just" is used therewith.

It can be understood that, although the terms "first," "second," etc. can be used herein to describe various elements, these elements are not to be limited by these terms. These terms are merely used to distinguish one element from another. Therefore, in the present specification, an element indicated by "first" can be the same as an element indicated by "second" without exceeding the technical scope of the present disclosure, unless otherwise mentioned.

A first horizontal axis direction, a second horizontal axis direction, and a vertical axis direction should not be construed as only a geometric relationship where a relationship therebetween is strictly perpendicular, and can denote having a broader directionality within a scope where elements of the present disclosure operate functionally.

The term "at least one" should be understood as including all possible combinations which can be suggested from one or more relevant items. For example, the meaning of "at least one of a first item, a second item, or a third item" can be each one of the first item, the second item, or the third item and also be all possible combinations that can be suggested from two or more of the first item, the second item, and the third item.

The respective features of the various embodiments of the present disclosure can be partially or entirely coupled to and combined with each other, and various technical linkages and modes of operation thereof are possible. These various embodiments can be performed independently of each other or can be performed in association with each other.

Wherever possible, the same reference numerals will be used throughout the drawings to refer to the same or like parts. Because a scale of each of the elements illustrated in the accompanying drawings is different from an actual scale for convenience of description, the disclosure is not limited to the scale illustrated in the drawings.

Hereinafter, a preferred example of a display device according to an embodiment of the present disclosure will be described in detail with reference to the accompanying drawings.

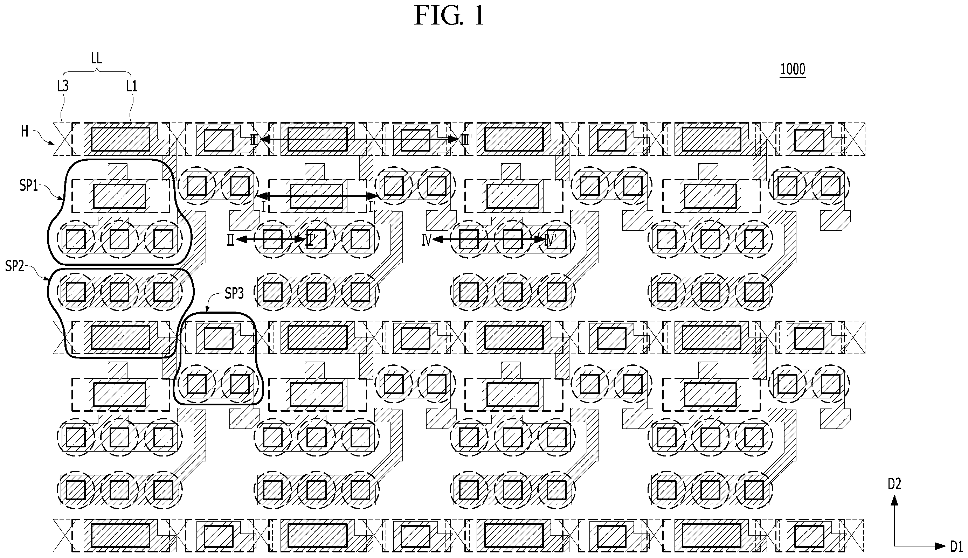

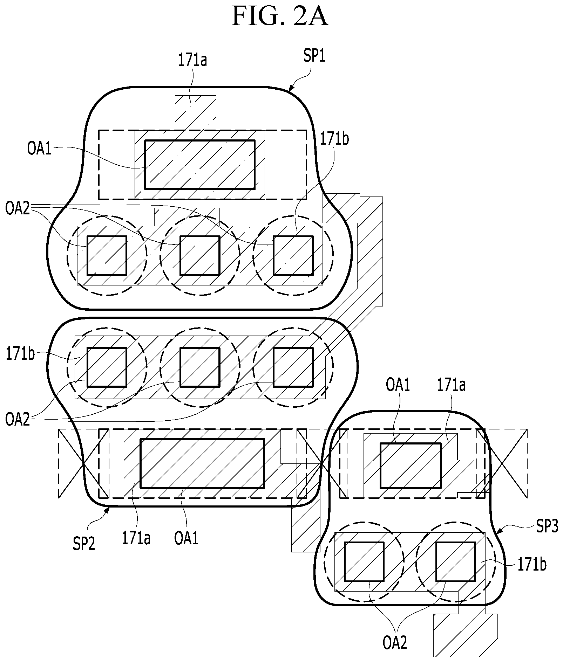

FIG. 1 is a plan view of a display device according to an embodiment of the present disclosure. FIGs. 2A to 2C are enlarged views showing various characteristics of the same components shown in FIG. 1.

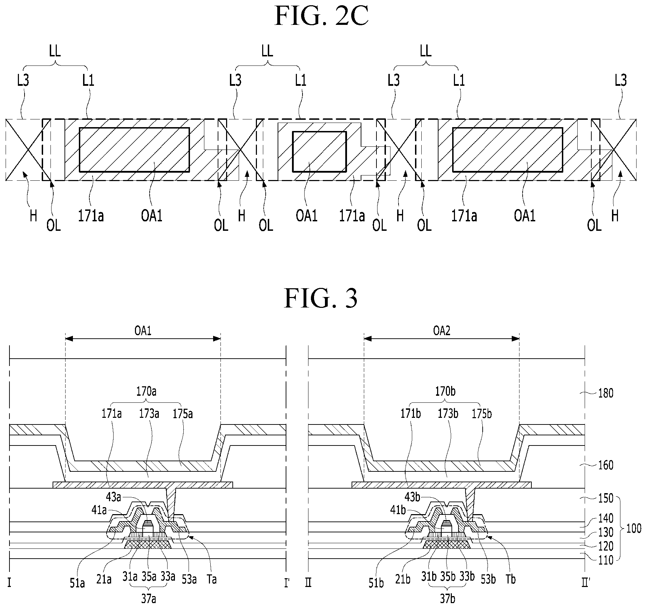

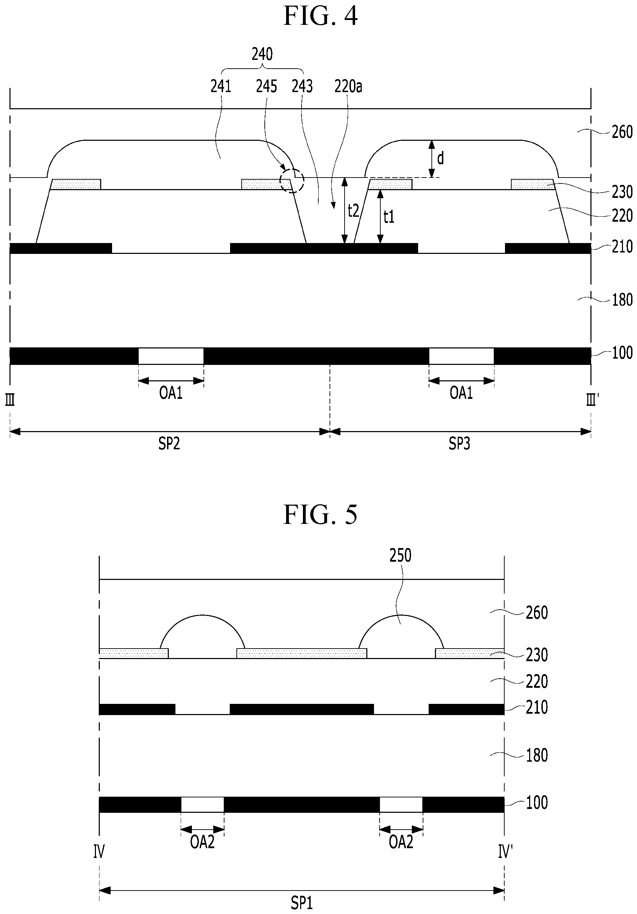

The display device according to an embodiment of the present disclosure can include a bank (160 in FIG. 3) including a first open portion OA1 included in each of a first sub-pixel SP1 and a second sub-pixel SP2, a first lens L1 disposed on the bank 160 to correspond to the first open portion OA1 of each of the first sub-pixel SP1 and the second sub-pixel SP2, an optical layer (220 in FIG. 4) disposed between the bank 160 and the first lens L1 and including a groove H having a first thickness t1 and formed between the first lens L1 corresponding to the first open portion OA1 of the first sub-pixel SP1 and the first lens L1 corresponding to the first open portion OA1 of the second sub-pixel SP2, and a filler L3 disposed in the groove H in the optical layer 220. The first lens L1 corresponding to the first open portion OA1 of the first sub-pixel SP1, the first lens L1 corresponding to the first open portion OA1 of the second sub-pixel SP2, and the filler L3 can be disposed in a row in a first direction D1.

Referring to FIG. 1, the display device of the present disclosure can include a plurality of unit pixels, each of which includes a first sub-pixel SP1, a second sub-pixel SP2, and a third sub-pixel SP3. The first to third sub-pixels SP1, SP2, and SP3 can be sub-pixels that emit light of different colors. For example, each of the first to third sub-pixels SP1 to SP3 can be a sub-pixel that emits one of red light, green light, and blue light.

The first to third sub-pixels SP1, SP2, and SP3 can be formed to have different area ratios. Correspondingly, a first lower electrode 171a and a second lower electrode 171b of each of the first to third sub-pixels SP1, SP2, and SP3 and a light-emitting portion and open portions OA (OA1 and OA2) of each of the first to third sub-pixels SP1, SP2, and SP3 can have different area ratios from those of the other sub-pixels. The area of each of the first to third sub-pixels SP1, SP2, and SP3 can be determined in consideration of the lifespan and luminous efficiency of the light-emitting device that emits light of a color corresponding thereto. That is, a sub-pixel that emits short-wavelength light can have a larger area size than the other sub-pixels, and a sub-pixel that emits long-wavelength light can have a smaller area size than the other sub-pixels. Based thereon, in the present disclosure, the area size of each sub-pixels that emit light of different colors and ratios between the area size of each sub-pixels can be different from each other, thereby making the lifespans and luminous efficiencies of the light-emitting devices of the sub-pixels uniform. For example, as shown in FIG. 1, the second sub-pixel SP2 can have an area size larger than area sizes for the first and third sub-pixels SP1 and SP3, and the third sub-pixel SP3 can have an area size smaller than the area sizes for first and second sub-pixels SP1 and SP2. However, the disclosure is not limited thereto. The arrangement, area sizes and area ratios of the first to third sub-pixels SP1, SP2, and SP3 can be different from those described above.

The first sub-pixel SP1 and the second sub-pixel SP2 can be alternately disposed in a second direction D2. The third sub-pixel SP3 can be disposed adjacent to the first sub-pixel SP1 and the second sub-pixel SP2 in the first direction D1 that intersects the second direction D2. Here, the first direction D1 and the second direction D2 can be directions that perpendicularly intersect each other. However, the placement of the first to third sub-pixels SP1, SP2, and SP3 of the present disclosure is not limited thereto.

Referring to FIGs. 2A to 2C together, each of the first to third sub-pixels SP1, SP2, and SP3 can include a first lower electrode 171a and a second lower electrode 171b. The first lower electrode 171a and the second lower electrode 171b can be provided independently of each other and can be driven independently by different driving circuits. The first lower electrode 171a and the second lower electrode 171b can be formed to have different areas. In addition, the first lower electrodes 171a of the first to third sub-pixels SP1, SP2, and SP3 can be formed to have different area sizes and corresponding ratios. Correspondingly, the second lower electrodes 171b of the first to third sub-pixels SP1, SP2, and SP3 can also be formed to have different area sizes and corresponding ratios.

The first lower electrode 171a can be longer in the first direction D1 than in the second direction D2. The first lower electrode 171a can include one first open portion OA1. The second lower electrode 171b can also be longer in the first direction D1 than in the second direction D2. In addition, the second lower electrode 171b can include a plurality of second open portions OA2.

The first open portion OA1 and the plurality of second open portions OA2 can be areas in which emitted light is radiated. For example, the first open portion OA1 and the second open portions OA2 can be areas exposed from the bank 160 disposed between light-emitting devices (170a and 170b in FIG. 3). In addition, the first open portion OA1 and the second open portions OA2 can have different sizes from an open portion formed by a black matrix 210 on an encapsulation film (180 in FIG. 3) covering the bank 160 and the light-emitting devices 170a and 170b or an open portion formed by a sensor electrode (230 in FIG. 3) overlapping the black matrix 210 (See FIG. 4). That is, the first open portion OA1 and the second open portions OA2 exposed by the bank 160 can have smaller sizes than the open portion formed by the black matrix 210 and the open portion formed by the sensor electrode 230. The first open portion OA1 and each of the second open portions OA2 can have different area sizes.

The first open portion OA1 can be arranged along the first direction D1 of the first lower electrode 171a. The first open portion OA1 can be longer in the first direction D1 than in the second direction D2.

The plurality of second open portions OA2 can be disposed in a row within the second lower electrode 171b to be spaced apart from each other in the first direction D1. A sum of the lengths of the plurality of second open portions OA2 in the first direction D1 can be less than the length of the second lower electrode 171b in the first direction D1. The length of each of the plurality of second open portions OA2 in the first direction D1 can be less than the length of the first open portion OA1 in the first direction D1. Each of the plurality of second open portions OA2 can be formed such that the length thereof in the first direction D1 is similar to the length thereof in the second direction D2.

There can be provided a first lens L1 corresponding to the first open portion OA1 and a plurality of second lenses L2 corresponding to the plurality of second open portions OA2. The first lens L1 and the plurality of second lenses L2 can have different shapes and different sizes. In addition, the first lens L1 and each of the second lenses L2 can have different area ratios when viewed in plan.

A first lens L1 corresponding to the first open portion OA1 can be provided. In correspondence with the shape of the first open portion OA1, the first lens L1 can be longer in the first direction D1 than in the second direction D2. The first lens L1 can be sized to cover the entire area of the first open portion OA1 of the first lower electrode 171a. In addition, the first lens L1 can be provided above the first lower electrode 171a, have a larger area than the first open portion OA1 and extend over at least the length of the first lower electrode 171a in the first direction D1. Referring to FIG. 4 together, the first lens L1 can be implemented as a semicylindrical lens having a length in the first direction D1. In detail, the first lens L1 can be implemented as a hemi-ellipsoidal lens that is cut along the long axis thereof.

The semicylindrical first lens L1 can have a rectangular section when viewed in a plan view and can have a semicircular section when cut along a cutting line extending in the second direction D2. In addition, the hemi-ellipsoidal first lens L1 can have an elliptical section when viewed in a plan view. Accordingly, the first lens L1 can limit the viewing angle in the second direction D2 without limiting the viewing angle in the first direction D1.

Second lenses L2 respectively corresponding to the plurality of second open portions OA2 can be provided. Each of the second lenses L2 can be sized to completely cover an area corresponding one of the plurality of second open portions OA2. In addition, the length of each of the second lenses L2 in the first direction D1 can be less than the length of the first lens L1 in the first direction D1. Each of the plurality of second lenses L2 can be implemented as a hemispherical lens or a domed shape lens.

The hemispherical second lens L2 can have a circular section when viewed in plan and can have a semicircular section when cut along a cutting line extending in the first direction D1 and when cut along a cutting line extending in the second direction D2. Such a hemispherical second lens L2 can limit the viewing angle in the first and second directions D1 and D2. For example, the first lens L1 can be for providing a wide viewing angle (e.g., a public viewing mode) and the second lens L2 can be for providing a narrow viewing angle (e.g., a privacy viewing mode).

As described above, the display device according to an embodiment of the present disclosure can be a display device capable of controlling/limiting the viewing angle using the hemi-ellipsoidal first lens L1 corresponding to the first lower electrode 171a and the plurality of hemispherical second lenses L2 corresponding to the second lower electrode 171b. The display device of the present disclosure can selectively achieve a wide viewing angle and a narrow viewing angle because a direction in which the first lens L1 limits the viewing angle and a direction in which the second lenses L2 limit the viewing angle are different from each other. Also, the display device can switch between a wide viewing angle mode (e.g., public viewing mode) by activating the subpixels corresponding to the first lenses L1 and a narrow viewing angle mode (e.g., private viewing mode) by activating the subpixels corresponding to the second lenses L2. Also, a third mode (e.g., high brightness mode) can be provided in which both the subpixels corresponding to the first lenses L1 and the subpixels corresponding to the second lenses L2 are all activated together (e.g., to improve brightness during a sunny day, etc.).

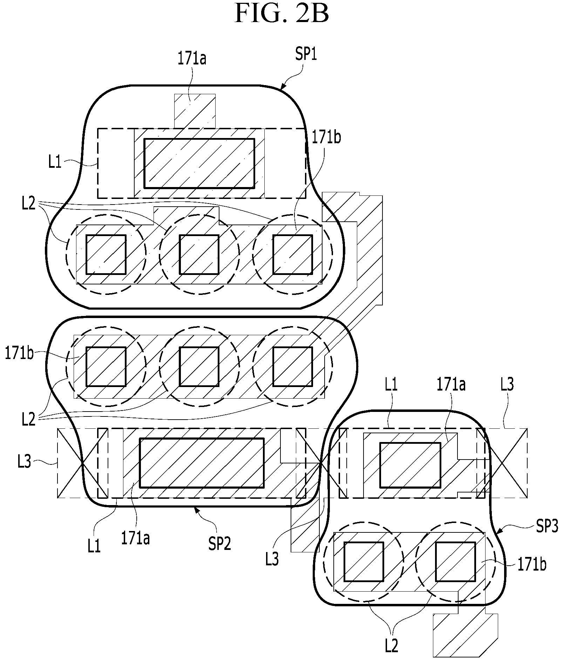

Referring to FIG. 2C, in the display device according to an embodiment of the present disclosure, a filling lens L3 can be disposed between adjacent lenses L1 or L2. In the display device according to an embodiment of the present disclosure, the filling lens L3 can be disposed between adjacent first lenses L1. That is, the filling lens L3 can be disposed between the first lenses L1 of adjacent sub-pixels. For example, as illustrated in Fig. 2B, the filling lens L3 can be disposed between the first lens L1 of sub-pixel SP2 and the first lens L1 of sub-pixel SP3. The filling lens L3 can be referred to as a filler.

The filling lenses L3 according to an embodiment can be disposed in all of areas between the first lenses L1. In some situations, the filling lenses L3 may be absent from some of the areas between the first lenses L1. If the filling lenses L3 are disposed in all of the areas between the first lenses L1, the first lenses L1 and the filling lenses L3 can be alternately disposed in the first direction D1.

An overlap portion OL in which the edge of the first lens L1 and the edge of the filling lens L3 adjacent to each other partially overlap with each other can be provided. Alternatively, a connection portion in which the edge of the first lens L1 and the filling lens L3 are connected to each other can be provided. Here, the connection portion between the first lens L1 and the filling lens L3 can overlap with the overlap portion OL between the first lens L1 and the filling lens L3. The first lens L1 and the filling lens L3 can be disposed in different layers and can be consecutively formed via the connection portion. Accordingly, the first lens L1 and the filling lens L3 can implement a line-type lens LL that is consecutively formed in the first direction D1 when viewed in plan. For example, a material for implementing the line-type lens LL can be laid down as a long continuous strip and grooves in the optical layer can be used to define and separate the first lenses L1 from each other (e.g., lens material can fall into the groove and define a step different between adjacent first lens L1). Also, since portions of the lens material is fitted within the grooves between adjacent subpixels, the adhering force for fixing the first lenses L1 can be improved and peeling can be prevented or minimized.

FIG. 3 is a cross-sectional view taken along lines I-I' and II-II' in FIG. 1. FIG. 3 is a cross-sectional view of a light-emitting device array 100 and the light-emitting devices 170a and 170b. That is, FIG. 3 is a cross-sectional view showing the driving array and the light-emitting devices corresponding to the first open portion and the second open portion of any one sub-pixel. In an example, FIG. 3 is a cross-sectional view of the first open portion OA1 and the second open portion OA2 of the first sub-pixel SP1.

Referring to FIG. 3, the display device of the present disclosure can include a thin-film transistor Ta and a light-emitting device 170a corresponding to the first open portion OA1 on the substrate 110, and can include a thin-film transistor Tb and a light-emitting device 170b corresponding to the second open portion OA2 on the substrate 110. In addition, the display device of the present disclosure can include a bank 160 disposed between the light-emitting devices 170a and 170b and an encapsulation film 180 covering the light-emitting devices 170a and 170b.

The substrate 110 can be divided into an active area in which a screen is displayed and a non-active area in which a screen is not displayed, and the active area can be constituted by a plurality of sub-pixels. The plurality of sub-pixels can include emission portions that actually emit light and non-emission portions that are formed around the emission portions and do not emit light. The emission portions can be referred to as the first open portion OA1 and the second open portion OA2 in FIG. 3. That is, in the present disclosure, because the first open portion OA1 and the second open portion OA2 are areas exposed from the bank 160, intermediate layers 173a and 173b between the first and second lower electrodes 171a and 171b and the upper electrodes 175a and 175b can be emission areas. For example, if the substrate 110 is a plastic substrate, the substrate 110 can include polyimide or polyamide.

On the substrate 110, a circuit device, which includes various signal lines such as a data line and a gate line, transistors such as a driving thin-film transistor, a switching thin-film transistor, and a sensing thin-film transistor, and a capacitor can be provided for each of the lower electrodes 171a and 171b. In the present disclosure, for convenience of description, one first thin-film transistor Ta driving the first lower electrode 171a and one second thin-film transistor Tb driving the second lower electrode 171b are illustrated.

The first thin-film transistor Ta can include an active layer 37a and a gate electrode 43a overlapping a channel region 35a of the active layer 37a with a gate insulating film 41a interposed therebetween, and can include a source electrode 51a and a drain electrode 53a respectively connected to two opposite sides of the active layer 37a.

The second thin-film transistor Tb can include an active layer 37b and a gate electrode 43b overlapping a channel region 35b of the active layer 37b with a gate insulating film 41b interposed therebetween, and can include a source electrode 51b and a drain electrode 53b respectively connected to two opposite sides of the active layer 37b.

The active layer 37a or 37b can include a source region 31a or 31b and a drain region 33a or 33b respectively provided at two opposite sides thereof and can include a channel region 35a or 35b disposed between the source region 31a or 31b and the drain region 33a or 33b. Each of the source region 31a or 31b and the drain region 33a or 33b is formed of a semiconductor material doped with an n-type or p-type dopant. The channel region 35a or 35b overlapping with the gate electrode 43a or 43b can be formed of a semiconductor material not doped with an n-type or p-type dopant.

The gate electrode 43a or 43b and the channel region 35a or 35b of the active layer 37a or 37b can have the same width and can be disposed to overlap with each other with the gate insulating film 41a or 41b interposed therebetween. The gate insulating film 41a or 41b can overlap with the channel region 35a or 35b of the active layer 37a or 37b in the same pattern as the gate electrode 43a or 43b. For example, the gate electrode 43a or 43b can take the form of a single layer or multiple layers made of molybdenum (Mo), aluminum (Al), chromium (Cr), gold (Au), titanium (Ti), nickel (Ni), neodymium (Nd), copper (Cu), or an alloy thereof. The gate insulating film 41a or 41b can be made of an inorganic insulating material. For example, the gate insulating film 41a or 41b can be implemented as a silicon oxide (SiOx) film, a silicon nitride (SiNx) film, a silicon oxynitride (SiOxNy) film, or a multilayered film thereof.

A light-shielding layer 21a or 21b on the substrate 110 is disposed under the active layer 37a or 37b while overlapping with at least the channel region 35a or 35b of the active layer 37a or 37b of the thin-film transistor Ta or Tb. The light-shielding layer 21a or 21b prevents external light from traveling to the thin-film transistor Ta or Tb through the substrate 110. For example, the light-shielding layer 21a or 21b can be implemented as a single layer made of a metallic material such as molybdenum (Mo), titanium (Ti), aluminum-neodymium (AINd), aluminum (Al), chromium (Cr), or an alloy thereof or can be formed in a multilayered structure including the above metallic materials.

A buffer film 120 can be disposed on the light-shielding layer 21a or 21b to cover the light-shielding layer 21a or 21b. For example, the buffer film 120 can take the form of a single layer or multiple layers made of silicon oxide (SiOx) or silicon nitride (SiNx).

An interlayer insulating film 130 can be disposed on the buffer film 120. The interlayer insulating film 130 can include a source contact hole and a drain contact hole respectively exposing the source region 31a or 31b and the drain region 33a or 33b of the active layer 37a or 37b and can cover the gate insulating film 41a or 41b and the gate electrode 43a or 43b. For example, the interlayer insulating film 130 can be made of an inorganic insulating material. For example, the interlayer insulating film 130 can be implemented as a silicon oxide (SiOx) film, a silicon nitride (SiNx) film, a silicon oxynitride (SiOxNy) film, or a multilayered film thereof.

The source electrode 51a or 51b and the drain electrode 53a or 53b can be disposed in the same layer on the interlayer insulating film 130. The source electrode 51a or 51b and the drain electrode 53a or 53b are connected to the source region 31a or 31b and the drain region 33a and 33b of the active layer 37a and 37b through the source contact hole and the drain contact hole, respectively. For example, each of the source electrode 51a or 51b and the drain electrode 53a or 53b can take the form of a single layer made of a metallic material such as molybdenum (Mo), aluminum (Al), chromium (Cr), gold (Au), titanium (Ti), nickel (Ni), neodymium (Nd), copper (Cu), or an alloy thereof or can be formed in a multilayered structure including the above metallic materials.

A passivation layer 140 can be disposed on the interlayer insulating film 130 to cover the thin-film transistor Ta or Tb. Accordingly, the thin-film transistor Ta or Tb can be protected by the passivation layer 140. For example, the passivation layer 140 can be a type of inorganic insulating film and can be implemented as a silicon oxide (SiOx) film, a silicon nitride (SiNx) film, a silicon oxynitride (SiOxNy) film, or a multilayered film thereof.

A first planarization film 150 can be disposed on the passivation layer 140. The first planarization film 150 can be formed to a thickness sufficient to provide a substantially planar surface on the uneven surface of the upper portion of the thin-film transistor Ta or Tb, and can be implemented as an organic insulating film. In a case in which the first planarization film 150 also functions to protect the thin-film transistor Ta or Tb, the passivation layer 140 can be omitted. For example, the first planarization film 150 can be a type of organic insulating film. For example, the first planarization film 150 can be implemented as a photo acryl film, a polyimide film, a benzocyclobutene resin film, or an acrylate film or, in some situations, can be implemented as a multilayered film thereof.

A first light-emitting device 170a, which corresponds to the first open portion OA1 and includes a first lower electrode 171a, an intermediate layer 173a, and an upper electrode 175a and a second light-emitting device 170b, which corresponds to the second open portion OA2 and includes a second lower electrode 171b, an intermediate layer 173b, and an upper electrode 175b, can be disposed on the first planarization film 150. The first light-emitting device 170a and the second light-emitting device 170b can be driven independently in response to different signals received from the different thin-film transistors Ta and Tb. The first light-emitting device 170a can be driven in such a manner that the intermediate layer 173a emits light as an electric field is formed between the first lower electrode 171a and the upper electrode 175a. The second light-emitting device 170b can be driven in such a manner that the intermediate layer 173b emits light as an electric field is formed between the second lower electrode 171b and the upper electrode 175b.

The first lower electrode 171a and the second lower electrode 171b can be provided together in each of the plurality of sub-pixels SP1, SP2, and SP3. Each of the first lower electrode 171a and the second lower electrode 171b can be formed in a multilayered structure including a transparent conductive film and an opaque conductive film having high reflection efficiency. The transparent conductive film of each of the first lower electrode 171a and the second lower electrode 171b can be formed of a material having a relatively large work function, e.g., indium-tin-oxide (ITO) or indium-zinc-oxide (IZO), and the opaque conductive film thereof can be formed in a single-layered or multilayered structure including a material selected from the group consisting of silver (Ag), aluminum (Al), copper (Cu), molybdenum (Mo), titanium (Ti), nickel (Ni), chromium (Cr), tungsten (W), and alloys thereof. For example, each of the first lower electrode 171a and the second lower electrode 171b can be formed in a structure in which a transparent conductive film, an opaque conductive film, and a transparent conductive film are sequentially stacked or can be formed in a structure in which a transparent conductive film and an opaque conductive film are sequentially stacked.

A bank 160, which covers the edge of each of the first lower electrode 171a and the second lower electrode 171b, can be disposed on the entire surface of the planarization film 150 while exposing the first open portion OA1 and the second open portion OA2. In addition, the bank 160 can include a light-absorbing material. For example, the bank 160 can include a black dye. Accordingly, the display device of the present disclosure can prevent optical interference and light leakage between adjacent sub-pixels.

The intermediate layers 173a and 173b can be disposed on the first and second lower electrodes 171a and 171b and the bank 160 over the entire area of the substrate 110. The intermediate layers 173a and 173b respectively corresponding to the first open portion OA1 and the second open portion OA2 can be formed in the same layer through the same process. Each of the intermediate layers 173a and 173b can be an organic layer having a single-stack structure constituted by multiple layers including a hole injection layer HIL, a hole transport layer HTL, an emission layer EML1 or EML2, an electron transport layer ETL, and an electron injection layer EIL. In some situations, each of the intermediate layers 173a and 173b can be formed in a tandem structure including multiple stacks (first stack and second stack), which include a first emission layer EML1 and a second emission layer EML2, respectively, and a charge generation layer (CGL) disposed between the stacks. The tandem structure is not limited to the illustrated 2-stack structure, but can be a multi-stack structure including three or more stacks. The first and second emission layers EML1 and EML2 in the multiple stacks can be emission layers emitting light of the same color among red light, green light, and blue light and can be patterned in each of the plurality of sub-pixels SP1, SP2, and SP3.

The upper electrodes 175a and 175b disposed on the intermediate layers 173a and 173b can be formed on the entire surface of the substrate 110 through a common mask. That is, the upper electrodes 175a and 175b respectively corresponding to the first open portion OA1 and the second open portion OA2 can be formed in the same layer through the same process. For example, the upper electrodes 175a and 175b can be made of a transparent conductive material such as indium-tin-oxide (ITO) or indium-zinc-oxide (IZO), or can be made of silver (Ag), aluminum (Al), magnesium (Mg), calcium (Ca), or an alloy thereof and can be formed to be thin enough to transmit light.

The encapsulation film 180 can be disposed on the upper electrodes 175a and 175b to cover the entire surface of the active area and the non-active area on the substrate 110. The encapsulation film 180 prevents oxygen and moisture from entering the light-emitting devices 170a and 170b, thereby improving the lifespan of the light-emitting display device. In an example, the encapsulation film 180 can be formed in a structure in which one or more pairs of an inorganic encapsulation film and an organic encapsulation film are stacked.

FIG. 4 is a cross-sectional view taken along line III-III' in FIG. 1, which shows a lens array of the first lenses adjacent to each other on the light-emitting device array 100. FIG. 5 is a cross-sectional view taken along line IV-IV' in FIG. 1, which shows a lens array of the second lenses adjacent to each other on the light-emitting device array 100.

Referring to FIGs. 4 and 5, the display device of the present disclosure can include a black matrix 210, an optical layer 220, a loss preventing lens structure 240, and a second planarization film 260, which are disposed on the encapsulation film 180 covering the light-emitting device array 100. The light-emitting device array 100 can include a substrate 110, a buffer film 120, an interlayer insulating film 130, a passivation layer 140, a first planarization film 150, and a bank 160 exposing the light-emitting devices 170a and 170b and the first and second open portions OA1 and OA2.

The black matrix 210 disposed on the encapsulation film 180 can overlap with the non-open portions except for the first and second open portions OA1 and OA2. That is, the black matrix 210 can overlap with the bank 160. The black matrix 210 can include a light-absorbing material. For example, the black matrix 210 can include a black dye. This black matrix 210 can prevent optical interference and light leakage between adjacent sub-pixels.

The optical layer 220 can be disposed on the black matrix 210. The optical layer 220 can include a groove 220a formed in a portion thereof corresponding to the non-open portion. In addition, the portion of the optical layer 220 except for the groove 220a can be disposed on the entire surface of the encapsulation film 180 and the black matrix 210. The groove 220a in the optical layer 220 according to an embodiment can correspond to an area between the first lenses 241 adjacent to each other in the first direction (D1 in FIG. 1).

The groove 220a in the optical layer 220 can be a portion that is depressed from the surface of the optical layer 220 to have a first thickness 11. For example, the groove 220a can be a type of trench disposed between adjacent first lenses L1. The groove 220a can expose the black matrix 210 . The groove 220a in the optical layer 220 can serve as a space into which the patterns of the first lenses 241 are reflowed and introduced in a process of forming the first lenses 241 on the optical layer 220. The reflowed material of the patterns of the first lenses 241 can flow into the groove 220a in the optical layer 220, which is lower than the surface of the optical layer 220. Due to the groove 220a formed in the optical layer 220, the display device of the present disclosure can separate the side surfaces of adjacent first lenses 241 from each other. In other words, lens material can be laid down for a row or column of subpixels as a long continuous strip, and the lens material can fall into the grooves between adjacent subpixels for individually defining a plurality of first lenses L1. Also, since space is securely obtained between adjacent first lenses L1, then a second planarization film 260 can be uniformly applied across the display since it can flow between adjacent first lenses L1 and the second planarization film 260 can reliably have a uniformly flat upper surface, which can improve image quality, reduce reflections, and better secure the first lenses L1 in place (e.g., a situation of the first lenses L1 connecting with each other to form a long dam structure that may block the application of second planarization film 260 can be prevented).

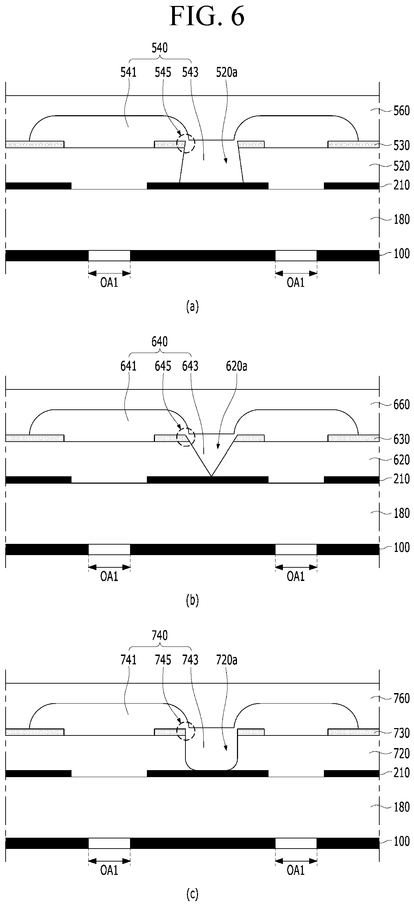

As shown in FIG. 4, the groove 220a according to an embodiment can have a trapezoidal shape that is reversely tapered such that the width of the bottom surface is shorter than the width of the top surface. However, the sectional shape of the groove 220a is not limited thereto. As shown in part (a) of FIG. 6, a groove 520a can have a trapezoidal shape that is tapered such that the width of the top surface is shorter than the width of the bottom surface. As shown in part (b) of FIG. 6, a groove 620a can have an inverted-triangular shape formed such that the apex faces the substrate 110. As shown in part (c) of FIG. 6, a groove 720a can have a semicircular or semielliptical shape formed to have a curved inner surface that is gradually narrowed in a direction toward the substrate 110. Correspondingly, filling lenses 543, 643, and 743 can be provided to fill the grooves 520a, 620a, and 720a shown in parts (a), (b) and (c) of FIG. 6, respectively. As described above, the sectional shape of the groove 220a of embodiments of the present disclosure is not limited to the shapes illustrated in the drawings and can be any of various other shapes, e.g. a polygonal or semicircular shape.

It is illustrated in parts (a), (b) and (c) of FIG. 6 that the grooves 520a, 620a, and 720a are selectively provided in some of areas between first lenses 541, 641, and 741, rather than being provided in all of the areas between the first lenses 541, 641, and 741. Optical layers 520, 620, and 720, sensor electrodes 530, 630, and 730, first lenses 541, 641, and 741, connection portions 545, 645, and 745, and second planarization films 560, 660, and 760 according to the embodiments shown in parts (a), (b) and (c) of FIG. 6 can be formed identically to the optical layer 220, the sensor electrode 230, the first lens 241, the connection portion 245, and the second planarization film 260 according to an embodiment.

The filling lens 243 can be disposed in the groove 220a in the optical layer 220, and first lenses 241 can be disposed on the optical layer 220. The first lens 241 and the filling lens 243 can be made of the same material. Also, the first lens 241, the connection portion 245 and the filling lens 243 can all be connected or in physical communication with each other (e.g., all parts of a same continuous strip of material). The first lens 241 and the filling lens 243 can be formed during the same process. In detail, the filling lens 243 can be formed during a reflow process of the first lens 241. Due to the characteristics of the reflow process, the edge of the first lens 241 can be connected to the filling lens 243 provided in the groove 220a, and thus a connection portion 245 can be formed between the first lens 241 and the filling lens 243. The connection portion 245 between the first lens 241 and the filling lens 243 can be provided on the groove 220a, as shown in FIG. 4. However, the connection portion 245 of embodiments of the present disclosure is not limited thereto. Depending on the extent to which the filling lens 243 occupies the interior of the groove 220a, the connection portion 245 can be provided in the groove 220a or can be provided on the surface of the optical layer 220 connected to the groove 220a. According to another embodiment, the connection portion 245 can be absent and the filling lens 243 can be disconnected or cut from the first lens 241 by a deep groove.

Each of the first lenses 241 can be provided corresponding to a respective one of the first open portions OA1 of the sub-pixels. Each of the first lenses 241 can be formed to have a larger area size than at least the first open portion OA1 of a corresponding one of the sub-pixels. For example, the area size of the first lens L1 in Fig. 2B is larger than the area size of the first open portion OA1 in Fig. 2A. In addition, the first lenses 241 can have different sizes according to the different sizes of the sub-pixels corresponding thereto. For example, as shown in FIG. 4, the length of the first lens 241 corresponding to the second sub-pixel SP2 in the first direction D1 can be greater than the length of the first lens 241 corresponding to the third sub-pixel SP3 in the first direction D1.

In FIG. 4, each of the first lenses 241 can be a lens having a wide viewing angle in the first direction D1 (e.g., for providing a wide angle viewing mode or a public viewing mode). The first lenses 241 can be disposed in a row in the first direction D1, and the filling lens 243 can be provided in the groove 220a in the optical layer 220, which is formed in a different layer than the first lenses 241, in the first direction D1 in which the first lenses 241 are disposed. A step difference "d" can be formed between each of the first lenses 241 and the filling lens 243. Accordingly, when the second planarization film 260 is formed, the material of the second planarization film can easily flow between adjacent first lenses 241 due to the step difference between each of the first lenses 241 disposed in a row in the first direction D1 and the filling lens 243 disposed between the first lenses 241. Thus, the entire surface of the second planarization film 260 can be formed to be flat and uniformly distributed across the subpixels. In addition, in the loss preventing lens structure 240 including the first lenses 241 and the filling lens 243, the first lenses 241 on the optical layer 220 are connected to the filling lens 243, which is formed in a different layer than the first lenses 241. Accordingly, the lenses on the optical layer 220 can be more firmly fixed in place within the display device of the present disclosure. In other words, a situation of the first lenses 241 becoming peeled off can be prevented. In addition, in the display device of the present disclosure in which the first lenses 241 correspond to the respective first open portions OA1, it is possible to separate the side surfaces of the first lenses 241 from each other without increasing the size of the non-open portion between the first open portions OA1. In other words, a plurality of the first lenses 241 can be packed closer together while still being clearly and individually defined and separated from each other, which can provide higher resolutions.

The filling lens 243 located between the first lenses 241 adjacent to each other in the first direction D1 can be provided corresponding to the non-open portion of the sub-pixel. The filling lens 243 can overlap with the bank 160 and the black matrix 210. The extent to which the filling lens 243 occupies the interior of the groove 220a can vary depending on conditions of the reflow process of the first lenses 241. The filling lens 243 can be provided on at least the bottom surface of the groove 220a. In the situation in which the groove 220a in the optical layer 220 exposes the black matrix 210, the filling lens 243 can be provided on the surface of the black matrix 210 exposed by the groove 220a. In addition, the second thickness t2 of the filling lens 243 can be greater than the first thickness t1 of the groove 220a. In some situations, the second thickness t2 of the filling lens 243 can be less than or equal to the first thickness t1 of the groove 220a. In this situation, the connection portion 245 between the filling lens 243 and the first lens 241 can be located in the groove 220a.

With the groove 220a between the first lenses 241, a reflow process creates the filling lens 243 formed inside the groove 220a in the optical layer. As a result, it creates a clearly defined step difference "d" between first lenses 241 and the filling lens 243. Subsequently, the step difference helps the second planarization film 260 to have a smooth, flat surface over the first lenses, since the second planarization film 260 can more easily flow across the first lenses and is not blocked or dammed.

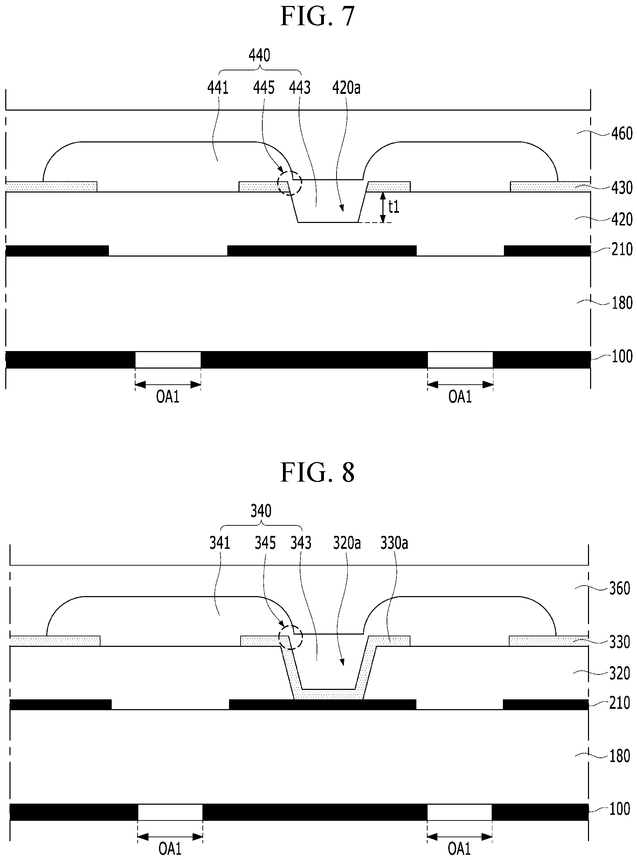

Referring to FIG. 7, the first thickness t1 of a groove 420a according to another embodiment can be less than the overall thickness of an optical layer 420. For example, according to some embodiments, the groove can penetrate all the way through optical layer 420 (e.g., as discussed above), but embodiments are not limited thereto and the groove can extend partially into the optical layer 420 as shown in FIG. 7. In this situation, the groove 420a can be depressed from the surface of the optical layer 420 only to a middle of the optical layer 420, and thus may not expose the black matrix 210. In this situation, first lenses 441 can have a different thickness or a different size from the first lenses 241 according to the embodiment discussed above. The other embodiment may require a relatively small space to receive the material of the first lenses 441, and accordingly, the first thickness t1 of the groove 420a can correspond to the distance from the top surface of the optical layer 420 to a middle of the optical layer 420. In addition, a filling lens 443 according to the other embodiment can be provided with a connection portion 445 connected to the edge of the first lens 441. A sensor electrode 430 and a second planarization film 460 according to the embodiment shown in FIG. 7 can be formed identically to the sensor electrode 230 and the second planarization film 260 according to the first embodiment discussed above.

Referring to FIG. 5, the second lenses 250 can be provided corresponding to the respective second open portions OA2 of the first sub-pixel SP1. The optical layer 220 between the second lenses 250 according to the first embodiment can also be provided in the non-open portion.

The sensor electrode 230 can be disposed on the optical layer 220. The sensor electrode 230 can overlap with the non-open portion and can overlap the bank 160 and the black matrix 210. Each of the first lens 241 and the second lens 250 can cover the edge of the sensor electrode 230. The sensor electrode 230 according to the first embodiment can be provided on the optical layer 220 in the non-open portion corresponding to the groove 220a to be spatially separated from another sensor electrode 230 with the groove 220a interposed therebetween.

Referring to FIG. 8, a sensor electrode 330a according to another embodiment can be disposed on an optical layer 320 to overlap with the non-open portion. Here, the sensor electrode 330a corresponding to a groove 320a in the optical layer 320 can be provided along the inner side of the groove 320a from the top of the optical layer 320 corresponding to the non-open portion. For example, the sensor electrode 330a can extend all the way across the groove 320a. In the situation in which the groove 320a exposes the black matrix 210, the sensor electrode 330a can be in contact with the black matrix 210 in the groove 320a. In addition, a connection portion 345 between a first lens 341 and a filling lens 343 can be disposed on and in contact with the sensor electrode 330a. The filling lens 343 and a second planarization film 360 according to the embodiment shown in FIG. 8 can be formed identically to the filling lens 243 and the second planarization film 260 according to the first embodiment.

The sensor electrode 230, 330, or 330a can be a touch electrode and can be made of a metal. In this situation, the sensor electrode 230, 330, or 330a as a touch electrode can include a plurality of transmitting electrodes and a plurality of receiving electrodes crossing each other and can detect touch through variation in capacitance between the plurality of transmitting electrodes and the plurality of receiving electrodes.

The second planarization film 260 can be disposed on the first lenses 241, the second lenses 250, and the filling lenses 220a. The second planarization film 260 can be implemented as an organic insulating film in order to provide a substantially planar surface on the uneven surfaces of the first lenses 241 and the second lenses 250 on the optical layer 220. Here, an inkjet printing process can be used to form the organic insulating film. The inkjet printing process can be performed by discharging the material of the second planarization film 260 onto the optical layer 220 having the first lenses 241 and the second lenses 250 formed thereon through nozzles. In this situation, it is difficult to regularly place the nozzles between the lenses. Thus, the nozzles can be irregularly disposed on the lenses and between the lenses. The material of the second planarization film 260 discharged from the irregularly placed nozzles can spread on the entire area of the substrate and can form a planar surface. In this situation, however, if there is no sufficient step between the first lenses disposed in the first direction, the discharged material of the second planarization film may not flow over a structure created by the first lenses, and thus the surface of the second planarization film may not be flat (e.g., if the first lenses are not clearly defined and appear connected together, they can from a type of dam structure that can impair the application of the second planarization film). Further, there can occur a line missing phenomenon, which is a phenomenon in which the first lenses disposed in the first direction escape from or peel away from an area between the second planarization film and the optical layer. Therefore, in the display device according to embodiments of the present disclosure, the groove 220a can be formed in a portion of the optical layer 220 located between the first lenses 241 disposed in the first direction D1 so that the material of the first lenses 241 flows into the groove 220a during the reflow process of the first lenses 241 which can improve an adhesive factor between the first lenses 241 and the optical layer. Accordingly, the step difference "d" can be formed between the first lenses 241 and the filling lens 243 that fills the groove 220a. In this way, in the display device of the present disclosure, since the step difference "d" is formed in vertical direction between top surfaces of the first lenses 241 consecutively disposed linearly in the first direction D1 and a top surface of the filling lens 243, the material of the second planarization film 260 can easily flow to an area between the first lenses 241 Accordingly, the surface of the second planarization film 260 can be formed to be flat and the second planarization film 260 can be uniformly distributed across the display screen. Further, since the entire surface of the second planarization film 260 is formed to be flat, the display device of the present disclosure can exhibit an effect of preventing line missing of the first lenses 241 disposed in the first direction D1.

The second planarization film 260 can be a type of organic insulating film, for example, a photo acryl film, a polyimide film, a benzocyclobutene resin film, or an acrylate film, or, in some situations, can be implemented as a multilayered film thereof.

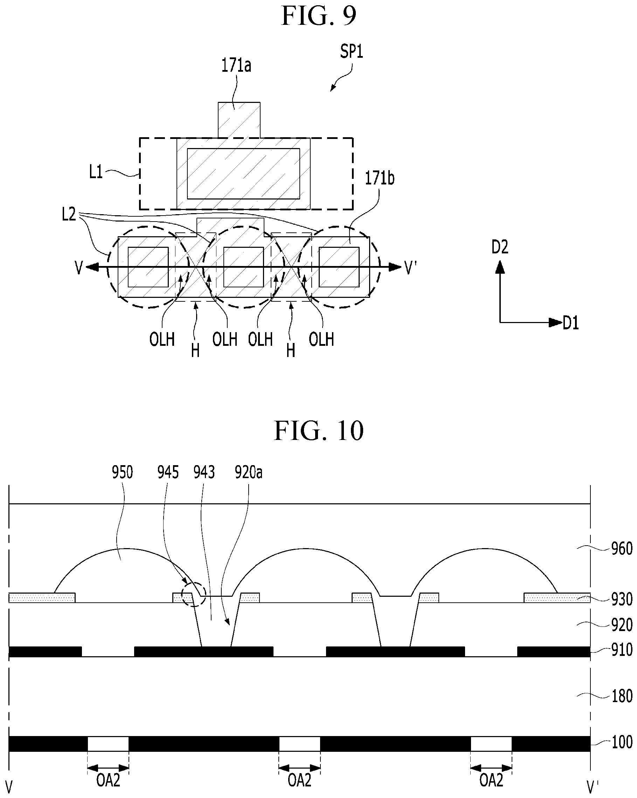

FIG. 9 is a plan view of a display device according to a second embodiment of the present disclosure. Although FIG. 9 illustrates a plan view of any one representative sub-pixel SP1, the display device of the present disclosure is not limited thereto. FIG. 10 is a cross-sectional view taken along line V-V' in FIG. 9. Hereinafter, description of the same configuration as that of the previous embodiment will be omitted.

Referring to FIG. 9, the display device according to the second embodiment of the present disclosure can include a groove H formed between the second lenses L2. The display device according to the second embodiment can include an overlap portion OLH in which the edge of the second lens L2 and the edge of the groove H partially overlap with each other. Although the second lenses L2 are illustrated as being disposed in one direction, the display device of the present disclosure is not limited thereto. The second lenses L2 can be disposed adjacent to each other in a placement structure different from that shown in the drawings (e.g., a zigzag arrangement, etc.). Even when the second lenses L2 are placed adjacent to each other with a different arrangement from that shown in the drawings, the groove H can be formed between the second lenses L2.

Referring to FIG. 10, the display device according to the second embodiment of the present disclosure can include an optical layer 920, which includes a groove 920a formed therein between second lenses 950, and a filling lens 943 that fills the groove 920a. The edge of each of the second lenses 950 can be connected to the filling lens 943, so that a connection portion 945 can be formed between each of the second lenses 950 and the filling lens 943.

Each of the second lenses 950 can be disposed on the optical layer 920 to correspond to a respective one of the second open portions OA2 exposed by the bank. Each of the second lenses 950 can have a circular planar shape and a semicircular sectional shape or a domed shape. The second lens 950 can be a lens that achieves a narrow viewing angle by limiting the viewing angle both in the first direction D1 and in the second direction D2.

The second lens 950 can be a lens with a narrow viewing angle both in the up-down direction (the second direction) and in the left-right direction (the first direction), and can be formed to be shorter in the first direction D1 than the first lens L1 that achieves a wide viewing angle in the left-right direction (the first direction). Thus, the second lens can be provided in plural in one sub-pixel in order to achieve uniform brightness in different viewing angle modes. In this situation, the plurality of second lenses 950 can be disposed within or over one second pixel electrode 171b, so that the spacing distance between the second lenses 950 adjacent to each other can be shorter than the spacing distance from the other lenses. If the spacing distance between the plurality of second lenses 950 is not sufficient, the plurality of second lenses 950 can be formed in a shape different from the originally designed shape. However, in the display device of the present disclosure, since the groove 920a is formed in the portion of the optical layer 920 located between the plurality of second lenses 950, the reflowed material of the plurality of second lenses 950 can flow into the groove 920a. Accordingly, the display device of the present disclosure can prevent the side portions of the plurality of second lenses 950 adjacent to each other from coming into contact with each other and can allow the plurality of second lenses 950 to be formed in the originally designed shape. In the display device according to embodiments of the present disclosure, each of the plurality of second lenses 950 can have a circular shape when viewed in plan and can have a semicircular sectional shape.

In addition, due to the characteristics of the reflow process, the edges of the plurality of second lenses 950 adjacent to each other can be connected to the filling lens 943. Accordingly, the connection portion 945 can be formed between each of the second lenses 950 and the filling lens 943. Also, the second lenses 950 can be more securely attached to the optical layer due to the increased contact surface area provided by the grooves. The display device according to the second embodiment may further include sensor electrodes 930 and a planarization film 960, which be formed similarly or identically as in the previously described embodiments.

Both the display device according to the first embodiment of the present disclosure and the display device according to the second embodiment of the present disclosure can be applied to one display device. That is, both the groove formed in the portion of the optical layer located between the first lenses according to the first embodiment and the groove formed in the portion of the optical layer located between the second lenses according to the second embodiment can be applied to one display device. Therefore, in the display device of the present disclosure, the planarization film can be formed evenly over the entire area, line missing phenomenon of the first lenses disposed linearly in the first direction can be prevented, and the second lenses can be formed in the originally designed shape.

In addition, in the display device of the present disclosure, the groove in the optical layer formed is not limited to only between the first lenses disposed in the first direction or only between the second lenses disposed adjacent to each other within one sub-pixel. In detail, in the display device of the present disclosure, the groove in the optical layer can be formed between any lenses adjacent to each other, of which the side surfaces are likely to come into contact with each other during the reflow process. That is, in the display device of the present disclosure, contact between the side surfaces of adj acent lenses can be prevented by the groove formed in the optical layer, thus the lenses can be formed in the originally designed shape.

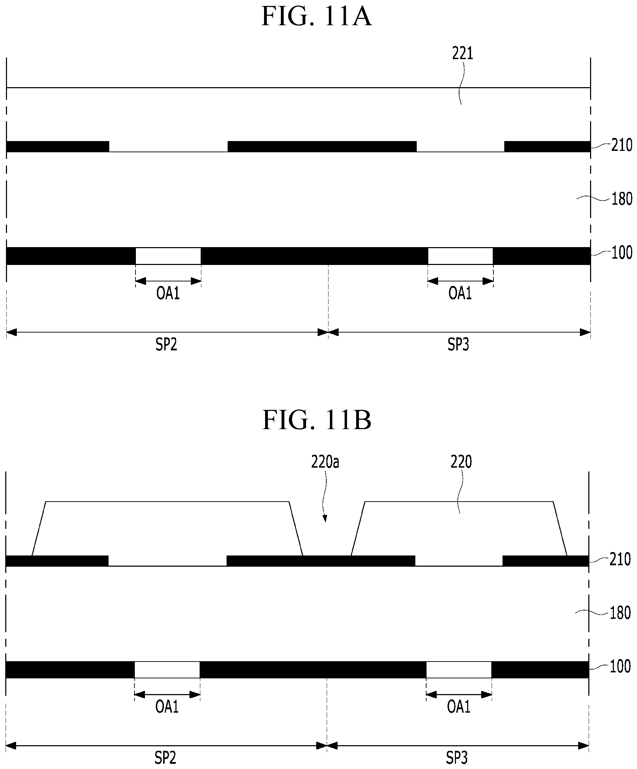

FIGs. 11A to 11F are cross-sectional views showing a process of manufacturing the display device according to the first embodiment of the present disclosure. That is, FIGs. 11A to 11F are cross-sectional views showing a process of manufacturing the display device shown in FIG. 4.

Referring to FIG. 11A, the encapsulation film 180 can be formed on the entire surface of the light-emitting device array 100 on which the light-emitting device and the bank have been formed. The black matrix 210 can be formed on the encapsulation film 180 patterned through a mask process to correspond to the non-open portion. An optical layer forming material 221 can be applied to the entire surface of the encapsulation film 180 on which the black matrix 210 has been formed.

Subsequently, referring to FIG. 11B, the optical layer forming material 221 can be patterned through a mask process so that the optical layer 220 is formed to overlap at least the open portions OA1 and OA2. In this process, a portion of the optical layer forming material 221 can be removed so that the groove 220a having the first thickness t1 is formed corresponding to the non-open portion between the first open portions OA1.

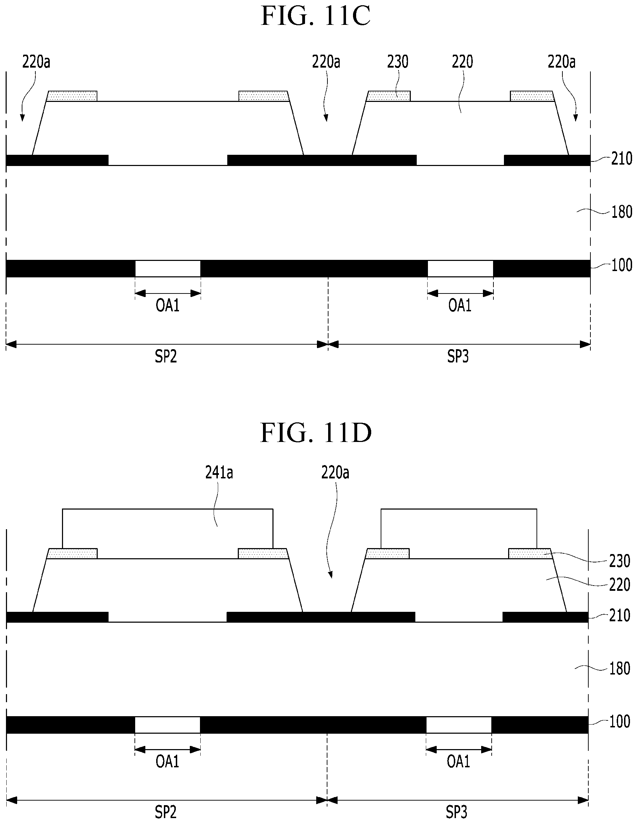

Subsequently, referring to FIG. 11C, the sensor electrode 230 can be formed on a portion of the optical layer 220 except for the groove 220a and the open portion OA1 patterned through a mask process.

Subsequently, referring to FIG. 11D, the first lens pattern 241a can be formed on a portion of the optical layer 220 overlapping with the open portion OA1 patterned through a mask process.

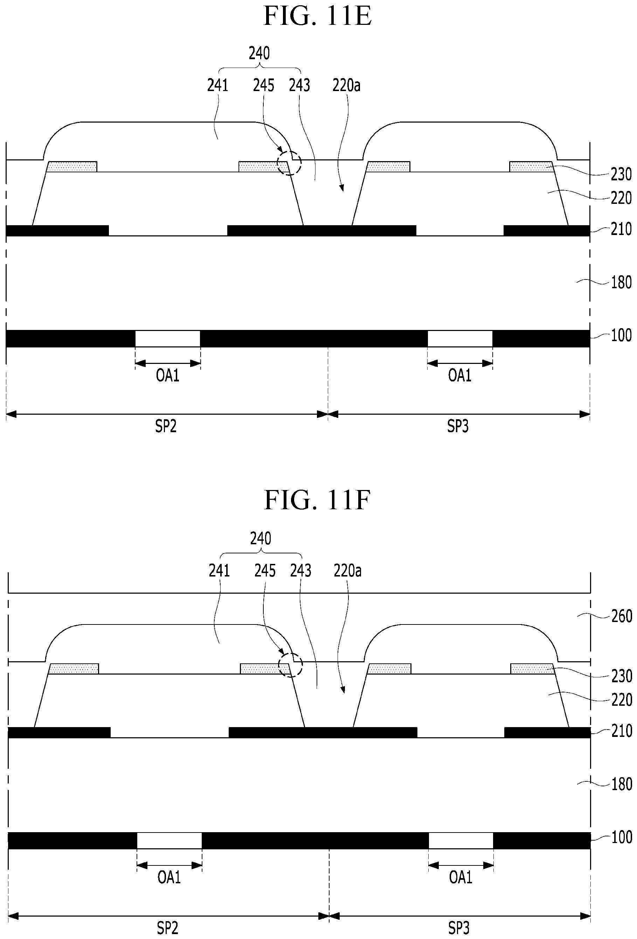

Subsequently, referring to FIG. 11E, the first lens pattern 241a with fluidity flows into the groove 220a through a reflow process, whereby the first lenses 241 can be formed on the optical layer 220 and the filling lens 243 can be formed in the groove 220a in the optical layer 220. Here, the connection portion 245 connecting the edge of each of the first lenses 241 and the filling lens 243 can be formed through the reflow process.

Subsequently, referring to FIG. 11F, the second planarization film 260 can be formed on the entire surface of the loss preventing lens structure 240 including the first lenses 241 and the filling lens 243. Due to the step difference d formed between the first lens 241 and the filling lens 243, the entire surface of the second planarization film 260 can be formed easily to be flat.

Accordingly, in the display device according to an embodiment of the present disclosure, the entire surface of the second planarization film 260 can be easily formed to be flat, and line missing phenomenon of the first lenses 241 consecutively disposed linearly together with the filling lens 243 in the first direction D1 can be prevented.

A display device according to an embodiment of the present disclosure can be described as follows.

A display device according to an embodiment of the present disclosure can include a bank exposing a first open portion included in each of a first sub-pixel and a second sub-pixel, a first lens disposed on the bank to correspond to the first open portion of each of the first sub-pixel and the second sub-pixel, an optical layer disposed between the bank and the first lens and including a groove having a first thickness and located between the first lens corresponding to the first open portion of the first sub-pixel and the first lens corresponding to the first open portion of the second sub-pixel, and a filler disposed in the groove in the optical layer. The first lens corresponding to the first open portion of the first sub-pixel, the first lens corresponding to the first open portion of the second sub-pixel, and the filler can be disposed in a row in a first direction.

According to a display device according to an embodiment of the present disclosure, the filler can be connected to an edge of the first lens.

According to a display device according to an embodiment of the present disclosure, the groove can overlap with the bank.

According to a display device according to an embodiment of the present disclosure, the first thickness can be less than the overall thickness of the optical layer.

A display device according to an embodiment of the present disclosure can further include a planarization film covering upper portions of the first lens and the filler.

According to a display device according to an embodiment of the present disclosure, the first lens can be longer in the first direction than in a second direction intersecting the first direction.

A display device according to an embodiment of the present disclosure can further include a plurality of second open portions included in each of the first sub-pixel and the second sub-pixel and second lenses respectively corresponding to the plurality of second open portions, and the length of each of the second lenses in the first direction can be less than the length of the first lens in the first direction.

According to a display device according to an embodiment of the present disclosure, the first lens can be provided in plural, and the plurality of first lenses can correspond to the first open portion of the first sub-pixel and the first open portion of the second sub-pixel.

A display device according to an embodiment of the present disclosure can further include an encapsulation film disposed between the optical layer and the bank and a black matrix disposed between the encapsulation film and the optical layer while overlapping with the bank, and the groove can expose the black matrix.

According to a display device according to an embodiment of the present disclosure, the filler can be in contact with the black matrix.

According to a display device according to an embodiment of the present disclosure, the filler can have a thickness greater than the first thickness.

A display device according to an embodiment of the present disclosure can further include a sensor electrode disposed on the optical layer while overlapping with the bank.

According to a display device according to an embodiment of the present disclosure, the sensor electrode can be spatially separated from another sensor electrode with the groove interposed therebetween.

According to a display device according to an embodiment of the present disclosure, the sensor electrode can be provided along the inner side of the groove from the top of the optical layer overlapping with the bank.

As is apparent from the above description, the display device of the present disclosure has the following effects.

First, in the display device of the present disclosure, since a groove is formed in a portion of an optical layer located under first lenses to correspond to an area between the first lenses disposed in a first direction, it is possible to separate the side surfaces of adjacent first lenses from each other without increasing the size of the space of a non-open portion.

Second, in the display device of the present disclosure, since a step difference is formed between the first lenses, the entire surface of a planarization film can be formed to be flat on the first lenses.

Third, in the display device of the present disclosure, since the entire surface of the planarization film is formed to be flat and the first lenses are connected to a filling lens disposed between the first lenses in the first direction and formed in a different layer from the first lenses, line missing phenomenon of the first lenses disposed on the same plane in the first direction can be prevented, and accordingly, mura effect due to line missing can be prevented.

Fourth, in the display device of the present disclosure, since the groove in the optical layer is formed not only between the first lenses disposed in the first direction but also between any lenses adjacent to each other, of which the side surfaces are likely to come into contact with each other during a reflow process, the lenses can be formed in the originally designed shape.

Fifth, in the display device of the present disclosure, it is possible to separate the side surfaces of the plurality of first lenses from each other and to evenly form the planarization film merely by forming the groove in the optical layer, and thus the amount of energy consumed for production of the display device can be reduced. As a result, the display device of the present disclosure is advantageous in terms of environment and process optimization, i.e., has environment/social/governance (ESG) effects.

Although example embodiments of the present disclosure have been described for illustrative purposes, those skilled in the art will appreciate that various modifications, additions, and substitutions are possible, without departing from the scope of the disclosure as disclosed in the accompanying claims. Therefore, the embodiment disclosed in the present disclosure is intended to illustrate the scope of the technical idea of the present disclosure, and the scope of the present disclosure is not limited by the embodiment. The scope of the present disclosure shall be construed based on the accompanying claims.

## Claims

1. A display device comprising:
a bank (160) exposing a first open portion (OA1) of a first sub-pixel and a first open portion (OA1) of a second sub-pixel;
a plurality of first lenses (L1, 241, 341, 441, 541, 641, 741) disposed to correspond to the first open portion (OA1) of the first sub-pixel and the first open portion (OA1) of the second sub-pixel;
an optical layer (220, 320, 420, 520, 620, 720, 920) disposed between the bank (160) and the plurality of first lenses (L1, 241, 341, 441, 541, 641, 741), the optical layer (220, 320, 420, 520, 620, 720, 920) including a first groove (H, 220a, 320a, 420a, 520a, 620a, 720a, 920a) between one of the plurality of first lenses (L1, 241, 341, 441, 541, 641, 741) corresponding to the first open portion (OA1) of the first sub-pixel and another one of the plurality of first lenses (L1, 241, 341, 441, 541, 641, 741) corresponding to the first open portion (OA1) of the second sub-pixel, the first groove (H, 220a, 320a, 420a, 520a, 620a, 720a, 920a) having a first thickness (t1); and
a filler (L3, 243, 343, 443, 543, 643, 743, 943) disposed in the first groove (H, 220a, 320a, 420a, 520a, 620a, 720a, 920a) of the optical layer (220, 320, 420, 520, 620, 720, 920),
wherein the filler (L3, 243, 343, 443, 543, 643, 743, 943) is aligned with the one of the plurality of first lenses (L1, 241, 341, 441, 541, 641, 741) corresponding to the first open portion (OA1) of the first sub-pixel and the another one of the plurality of first lenses (L1, 241, 341, 441, 541, 641, 741) corresponding to the first open portion (OA1) of the second sub-pixel, in a first direction (D1).

2. The display device according to claim 1, wherein the filler (L3, 243, 343, 443, 543, 643, 743, 943) is connected to an edge of one or more of the plurality of first lenses (L1, 241, 341, 441, 541, 641, 741).

3. The display device according to claim 1 or 2, wherein the first groove (H, 220a, 320a, 420a, 520a, 620a, 720a, 920a) overlaps with the bank (160).

4. The display device according to any of claims 1 to 3, wherein each of the plurality of first lenses (L1, 241, 341, 441, 541, 641, 741) has a length in the first direction (D1) longer than a length in a second direction (D2) intersecting the first direction (D1).

5. The display device according to claim 4, further comprising:
a plurality of second lenses (L2, 250, 950) disposed on the first sub-pixel and the second sub-pixel,
wherein each of the first sub-pixel and the second sub-pixel includes a plurality of second open portions (OA2) exposed by the bank (160),
wherein the plurality of second open portions (OA2) are respectively disposed to correspond to the plurality of second lenses (L2, 250, 950), and
wherein a length of each of the plurality of second lenses (L2, 250, 950) in the first direction (D1) is less than a length of each of the plurality first lenses (L1, 241, 341, 441, 541, 641, 741) in the first direction (D1),
wherein, preferably, the optical layer (220, 320, 420, 520, 620, 720, 920) includes a second groove (H) disposed between the plurality of second lenses (L2, 250, 950) of the first sub-pixel.

6. The display device according to any of claims 1 to 5, further comprising:
an encapsulation layer (180) disposed between the optical layer (220, 320, 420, 520, 620, 720, 920) and the bank (160); and
a black matrix (210, 910) disposed between the encapsulation layer (180) and the optical layer (220, 320, 420, 520, 620, 720, 920), the black matrix (210) overlapping with the bank (160),
wherein the first groove (H, 220a, 320a, 420a, 520a, 620a, 720a, 920a) exposes the black matrix (210, 910),
wherein, preferably, the filler (L3, 243, 343, 443, 543, 643, 743, 943) is in contact with the black matrix (210, 910).

7. The display device according to any of claims 1 to 6, wherein the filler (L3, 243, 343, 443, 543, 643, 743, 943) has a thickness (t2) greater than the first thickness (t1).

8. The display device according to any of claims 1 to 7, further comprising a plurality of sensor electrodes (230, 330, 330a, 430, 530, 630, 730, 930) disposed on the optical layer (220, 320, 420, 520, 620, 720, 920),
wherein the plurality of sensor electrodes (230, 330, 330a, 430, 530, 630, 730, 930) overlap with the bank (160), and
wherein the first groove (H, 220a, 320a, 420a, 520a, 620a, 720a, 920a) is between two adjacent sensor electrodes among the plurality of sensor electrodes (230, 330, 330a, 430, 530, 630, 730, 930),
wherein, preferably, one of the plurality of sensor electrodes (230, 330, 330a, 430, 530, 630, 730, 930) extends across the first groove (H, 220a, 320a, 420a, 520a, 620a, 720a, 920a).

9. A display device comprising:
a plurality of sub-pixels (SP1, SP2, SP3), each of the plurality of sub-pixels (SP1, SP2, SP3) including a first lower electrode (171a) and a second lower electrode (171b);
a first lens (L1, 241, 341, 441, 541, 641, 741) overlapping with a first open portion (OA1) of the first lower electrode (171a), the first lens (L1, 241, 341, 441, 541, 641, 741) having a length in a first direction (D1) longer than a length in a second direction (D2) intersecting the first direction (D1);
a plurality of second lenses (L2, 250, 950) respectively corresponding to a plurality of second open portions (OA2) of the second lower electrode (171b),
each of the plurality of second lenses (L2, 250, 950) having a length in the first direction (D1) less than the length of the first lens (L1, 241, 341, 441, 541, 641, 741) in the first direction (D1); and
a filling lens (L3, 243, 943) disposed on a different layer than the first lens (L1, 241, 341, 441, 541, 641, 741) and the plurality of second lenses (L2, 250, 950),
wherein the filling lens (L3, 243, 943) is disposed between the first lens (L1, 241, 341, 441, 541, 641, 741) of one sub-pixel among the plurality of sub-pixels (SP1, SP2, SP3) and the first lens (L1, 241, 341, 441, 541, 641, 741) of another sub-pixel among the plurality of sub-pixels (SP1, SP2, SP3) adjacent to the one sub-pixel in the first direction (D1).

10. The display device according to claim 9, further comprising an optical layer (220, 320, 420, 520, 620, 720, 920) covering the first lower electrode (171a) and the second lower electrode (171b),
wherein the first lens (L1, 241, 341, 441, 541, 641, 741) and the plurality of second lenses (L2, 250, 950) are disposed on the optical layer (220, 320, 420, 520, 620, 720, 920),
wherein the optical layer (220, 320, 420, 520, 620, 720, 920) includes a groove (H, 220a, 320a, 420a, 520a, 620a, 720a, 920a), and
wherein the filling lens (L3, 243, 943) is disposed in the groove (H, 220a, 320a, 420a, 520a, 620a, 720a, 920a in the optical layer (220, 320, 420, 520, 620, 720, 920).

11. The display device according to claim 9 or 10, wherein the filling lens (L3, 243, 943) is disposed between the plurality of second lenses (L2, 250, 950) in each of the plurality of sub-pixels (SP1, SP2, SP3),
wherein, preferably, the filling lens (L3, 243, 943) is connected to two adjacent second lenses (L2, 250, 950) among the second lenses (L2, 250, 950).

12. A display device comprising:
a bank (160) including a first open portion (OA1) for a first light-emitting device (170a) and a second open portion (OA2) for a second light-emitting device (170b);
an optical layer (220, 320, 420, 520, 620, 720, 920) overlapping with the first open portion (OA1) and the second open portion (OA2);
a first lens (L1, 241, 341, 441, 541, 641, 741) disposed on the optical layer (220, 320, 420, 520, 620, 720, 920) and overlapping with the first open portion (OA1);
a second lens (L2, 250, 950) disposed on the optical layer (220, 320, 420, 520, 620, 720, 920) and overlapping with the second open portion (OA2);
a first groove (H, 220a, 320a, 420a, 520a, 620a, 720a, 920a) in the optical layer (220, 320, 420, 520, 620, 720, 920) between the first lens (L1, 241, 341, 441, 541, 641, 741) and the second lens (L2, 250, 950); and
a filler (L3, 243, 343, 443, 543, 643, 743, 943) disposed in the first groove (H, 220a, 320a, 420a, 520a, 620a, 720a, 920a) of the optical layer (220, 320, 420, 520, 620, 720, 920).

13. The display device according to claim 12, wherein:
the filler (L3, 243, 343, 443, 543, 643, 743, 943) is connected to the first lens (L1, 241, 341, 441, 541, 641, 741) and the second lens (L2, 250, 950), and
the filler (L3, 243, 343, 443, 543, 643, 743, 943), the first lens (L1, 241, 341, 441, 541, 641, 741) and the second lens (L2, 250, 950) include a same material;
and/or
wherein a thickness of the first groove (H, 220a, 320a, 420a, 520a, 620a, 720a, 920a) is equal to or less than a thickness of the optical layer (220, 320, 420, 520, 620, 720, 920).

14. The display device according to claim 12 or 13, further comprising:
a planarization film (260, 360, 460, 560, 660, 760, 960) disposed on the first lens (L1, 241, 341, 441, 541, 641, 741) and the second lens (L2, 250, 950), a portion of the planarization film (260, 360, 460, 560, 660, 760, 960) extending between the first lens (L1, 241, 341, 441, 541, 641, 741) and the second lens (L2, 250, 950),
wherein the planarization film (260, 360, 460, 560, 660, 760, 960) has a uniformly flat upper surface.

15. The display device according to any of claims 12 to 14, wherein the first lens (L1, 241, 341, 441, 541, 641, 741) and the second lens (L2, 250, 950) are disposed along a same line, and
wherein each of the first lens (L1, 241, 341, 441, 541, 641, 741) and the second lens (L2, 250, 950) has a semicylindrical shape.
